# FASCICULE DE BREVET EUROPEEN

(11) **EP 0 840 539 B1**
(45) Date de publication et mention de la délivrance du brevet: **10.10.2007**
(21) Numéro de dépôt: 97402598.3
(22) Date de dépôt: 31.10.1997
(51) Int. Cl.: H05K 1/02, H05K 9/00, H04B 3/28

(54) **Equipement de télécommunication filaire avec protection contre des parasites électromagnétiques**
Verdrahtete Telekommunikationseinrichtung mit Schutz gegen elektromagnetische Interferenz
Wired telecommunication equipment with protection against electromagnetic interference

(30) Priorité: 04.11.1996 FR 9613394
(43) Date de publication de la demande: 06.05.1998
(73) Titulaire: Ericsson France, 91300 Massy (FR)
(72) Inventeur: Couland, Charles, 91400 Orsay (FR)
(74) Mandataire: Loisel, Bertrand

(56) Documents cités:
- WO-A-96/07290
- FR-A- 2 729 510
- GB-A- 2 268 336

## Description

La présente invention concerne le domaine de la protection des équipements de télécommunication contre des parasites électromagnétiques de type transitoire rapide.

Un équipement concerné par cette protection est du type comportant des premier et second connecteurs pour le raccordement à des première et seconde lignes, respectivement, et un circuit imprimé multicouche, dont une région supporte des composants de traitement de signal, chacune des première et seconde lignes comportant au moins deux conducteurs électriques, le circuit imprimé incorporant des liaisons électriques entre les connecteurs et lesdits composants.

Il s'agit typiquement d'un équipement de réseau numérique tel qu'une terminaison numérique de réseau (TNR) ou encore un répéteur. Une TNR est un équipement qui se place aux abords d'un site d'abonné numérique (par exemple sur un palier d'appartement) et qui assure les transformations de signaux, requises par les formats et protocoles de transmission numérique employés, entre une ligne de réseau raccordée à une interface de la TNR appelée interface U et une ligne d'abonné raccordée à une autre interface de la TNR appelée interface S.

Il est généralement spécifié qu'un équipement tel qu'une TNR puisse être proche (quelques centimètres) d'un élément raccordé électriquement à la terre (par exemple les fers d'armature d'un mur en béton armé sur lequel serait installé un compartiment destiné à recevoir l'équipement). Dans ces conditions, les perturbations électromagnétiques causées par les coupures de moteurs électriques, ou d'autres charges inductives, situés à proximité de l'équipement peuvent être induites par couplage dans les lignes raccordées à l'équipement. Ces parasites peuvent être de forte amplitude avec des temps de montée très courts (plusieurs centaines de volts en quelques nanosecondes). Ces parasites s'écoulent vers la terre, en s'évanouissant relativement rapidement dans les câbles. Mais il convient d'éviter qu'ils puissent atteindre les composants de traitement de signal de l'équipement, sans quoi ils provoqueraient des erreurs de transmission.

En général, cette protection est effectuée en prévoyant que les liaisons électriques entre les connecteurs de l'équipement et les composants de traitements de signal soient inductives, des petites bobines d'inductance étant à cet effet montées sur le circuit imprimé près des connecteurs. Mais les capacités parasites existant entre les spires adjacentes d'une bobine diminuent son impédance vis-à-vis des perturbations les plus rapides, ce qui limite sensiblement l'efficacité de la protection.

Les documents GB-A-2 268 336 et FR-A-2 729 510 décrivent des équipements de raccordement électrique comprenant des couplages capacitifs.

Par ailleurs, le document WO-A-9 607 290 présente un circuit imprimé comportant des composants de traitement de signal.

Un but de la présente invention est de proposer des moyens simples et économiques pour immuniser efficacement l'équipement contre des parasites intenses et rapides.

L'invention propose ainsi un équipement du type indiqué au début, dans lequel le circuit imprimé incorpore en outre des premières métallisations associées au premier connecteur qui les relie respectivement aux conducteurs de la première ligne, et des secondes métallisations associées au second connecteur qui les relie respectivement aux conducteurs de la seconde ligne, et dans lequel les premières métallisations et les secondes métallisations appartiennent à des couches différentes du circuit imprimé et sont situées les unes en face des autres pour réaliser un couplage capacitif entre les deux lignes.

En présence de parasites à haute fréquence, ce couplage capacitif intégré dans le circuit imprimé procure une faible impédance entre les deux lignes. Des parasites à haute fréquence survenant sur l'une des deux lignes peuvent alors être déviés vers l'autre ligne, où ils s'évanouiront sans atteindre les composants de traitement de signal.

En plus de son efficacité, cette protection de l'équipement présente l'avantage de ne rien coûter puisqu'elle fait simplement appel à un dessin judicieux des couches du circuit imprimé et non à des composants discrets de filtrage.

Pour limiter la propagation par rayonnement d'une perturbation vers les composants de traitement de signal, la région du circuit imprimé qui les supporte comporte un plan de masse situé à distance des connecteurs et des premières et secondes métallisations. Et pour limiter la propagation par conduction, on agence les liaisons électriques entre les connecteurs et les composants de traitement de signal de façon qu'elles soient essentiellement inductives, avec des capacités parasites minimales. On prévoit ainsi que ces liaisons consistent essentiellement en des pistes métalliques sensiblement parallèles que les connecteurs relient respectivement aux conducteurs électriques des lignes.

D'autres particularités et avantages de la présente invention apparaîtront dans la description ci-après d'un exemple de réalisation non limitatif, en référence aux dessins annexés, dans lesquels :
- la figure 1 est une vue schématique en perspective d'un équipement selon l'invention, et
- la figure 2 est un graphique montrant l'amélioration que procure l'invention quant au taux d'erreur observé en présence de parasites rapides.

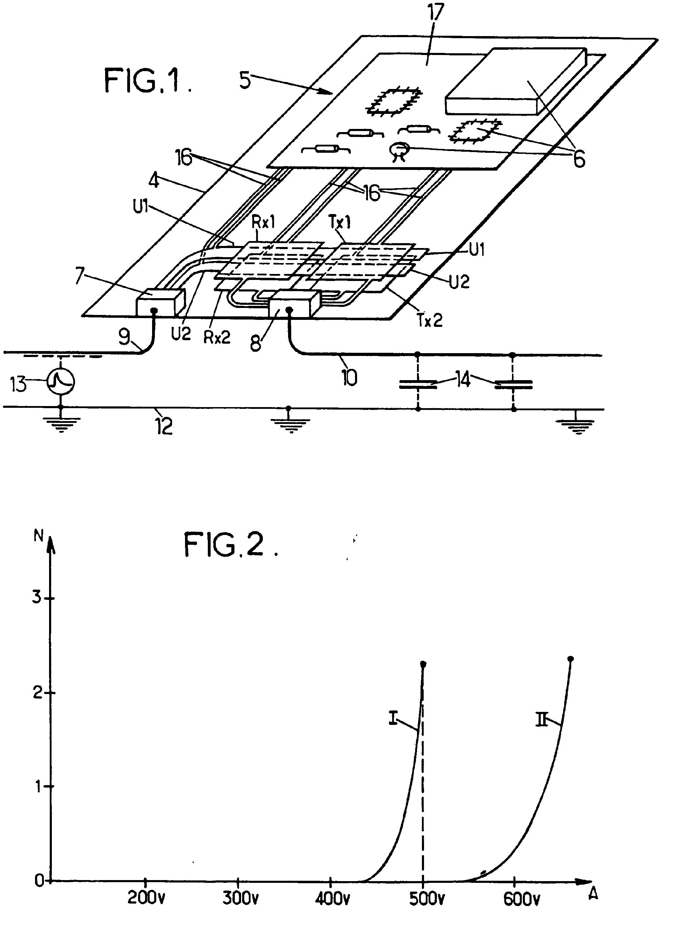

La figure 1 illustre l'application de la présente invention à un équipement de télécommunication filaire consistant en une terminaison numérique de réseau (TNR). La TNR comprend un circuit imprimé multicouche 4 de forme générale rectangulaire dont une région 5 supporte des composants de traitement de signal 6. Sur le bord du circuit imprimé 4 opposé à la région 5 sont disposés deux connecteurs, l'un 7 constituant une interface U pour le raccordement d'une ligne de réseau 9, et l'autre 8 constituant une interface S pour le raccordement d'une ligne d'abonné 10.

S'agissant d'un réseau numérique à intégration de services (RNIS), la ligne de réseau 9 raccordée à l'interface U se compose classiquement de deux conducteurs électriques procurant une liaison bidirectionnelle à 160 kbit/s, et la ligne d'abonné 10 raccordée à l'interface S se compose de quatre conducteurs procurant deux liaisons de sens contraire à 192 kbit/s. Les composants 6 assurent de façon classique les transformations de signaux requises entre les interfaces U et S.

Sur la figure 1, on a représenté la terre électrique 12 supposée proche de la TNR. La référence 13 symbolise un générateur de transitoires rapides qui, en raison de la proximité de la terre 12, peuvent être induits par couplage dans l'une des lignes raccordées aux connecteurs 7, 8, à savoir la ligne de réseau 9 dans le cas particulier considéré. Dans la pratique, ces transitoires peuvent être générés par des coupures de charges inductives telles que des moteurs (d'aspirateur par exemple) se trouvant près de la TNR. Ces transitoires peuvent provoquer des variations de tension de plusieurs centaines de volts pendant quelques nanosecondes. Il convient de prendre des dispositions pour que de telles perturbations n'atteignent pas les composants de traitement de signal 6 de la TNR.

A cet effet, l'invention préconise de dévier ces perturbations vers l'autre ligne 10 raccordée à la TNR, où elles pourront s'évanouir assez rapidement compte tenu des couplages capacitifs existant avec la terre 12, symbolisés par les condensateurs 14 sur la figure 1.

Cette déviation des perturbations est réalisée grâce à un couplage capacitif entre les connecteurs 7, 8, obtenu au moyen de métallisations judicieusement agencées dans les couches du circuit imprimé 4 et qui forment des plaques de condensateurs. Ce couplage capacitif doit être suffisant pour immuniser efficacement les composants 6 contre des perturbations rapides, sans être trop important pour éviter d'affecter les signaux dans la bande passante de transmission. On a déterminé que, dans le cas des valeurs numériques mentionnées plus haut pour un RNIS, le couplage capacitif global entre les deux lignes 9, 10 est avantageusement compris entre 150 et 300 picofarads.

Les métallisations U1, U2, Rx1, Rx2, Tx1, Tx2 sont situées à proximité des connecteurs 7, 8 qui les relient chacune à un conducteur respectif de l'une des lignes 9, 10. Des pistes métalliques 16 s'étendent au sein du circuit imprimé 4 entre les métallisations U1, U2, Rx1, Rx2, Tx1, Tx2 et la région 5 supportant les composants 6, où ces pistes sont reliées de manière appropriée aux composants 6.

Comme le montre la figure 1, la région 5 comporte un plan de masse métallisé 17 servant, comme il est usuel dans la technique des circuits imprimés, à distribuer le potentiel de la masse aux composants 6 qui en ont besoin. Ce plan de masse 17 est situé à distance des connecteurs 7, 8 et des métallisations U1, U2, Rx1, Rx2, Tx1, Tx2, afin de minimiser le risque qu'il soit atteint par une perturbation rapide se propageant par rayonnement depuis le bord opposé du circuit imprimé. Le plan de masse 17 est de préférence éloigné d'au moins 2 centimètres des connecteurs et des métallisations.

Entre le plan de masse 17 et les métallisations U1, U2, Rx1, Rx2, Tx1, Tx2, les pistes 16 sont parallèles et étroites, par exemple rectilignes, de manière à être essentiellement inductives en minimisant les couplages capacitifs. L'inductance longitudinale de chaque paire de piste 16 est de préférence d'au moins 20 nanohenrys.

Dans l'agencement représenté sur la figure 1, les deux métallisations U1, U2 associées au connecteur 7 de l'interface U consistent en deux bandes situées dans la même couche du circuit imprimé 4 parallèlement au bord où se trouvent les connecteurs 7, 8. Les deux métallisations Rx1, Rx2 associées au connecteur de l'interface S pour le sens de réception consistent en deux plaques ayant la même forme sensiblement carrée, situées l'une en face de l'autre dans deux couches du circuit imprimé 4 qui se trouvent de part et d'autre de la couche des métallisations U1, U2. Ces métallisations Rx1, Rx2 prennent en sandwich un tronçon de chacune des bandes constituant les métallisations U1, U2 de manière à réaliser le couplage capacitif souhaité. Les deux métallisations Tx1, Tx2 associées au connecteur de l'interface S pour le sens d'émission consistent en deux plaques ayant la même forme sensiblement carrée, situées l'une en face de l'autre dans les mêmes couches que les métallisations Rx1, Rx2. Ces métallisations Tx1, Tx2 prennent en sandwich un autre tronçon de chacune des bandes constituant les métallisations U1, U2 de manière à réaliser le couplage capacitif souhaité.

On notera que dans le cas où l'invention est appliquée à un équipement, tel qu'un répéteur, qui se raccorde à deux lignes ayant chacune deux conducteurs seulement, on pourra adopter un agencement semblable à celui de la figure 1, en supprimant l'une des paires de métallisations représentées, par exemple la paire Tx1, Tx2.

L'efficacité de la protection contre des perturbations rapides peut être appréciée sur le graphique de la figure 2, obtenu en mesurant le nombre moyen N de fautes de transmission par minute sur un canal à 64 kbit/s en fonction de l'amplitude A des transitoires rapides générés dans l'une des deux lignes. La courbe I représente le nombre de fautes observées en l'absence de la protection par couplage capacitif selon l'invention. On voit que pour une amplitude de 500 volts, spécifiée par certaines normes, le nombre de fautes de transmission est significatif, alors que ce nombre est négligeable lorsqu'il est fait appel à la protection selon l'invention (courbe II). Pour un nombre de fautes donné, l'équipement selon l'invention est capable de faire face à des perturbations rapides d'amplitude sensiblement plus grande. La courbe II a été obtenue dans un cas où le couplage capacitif global C entre les deux lignes était de 160 pF, l'inductance L de chaque paire de pistes 16 était de l'ordre de 20 nH et la distance d entre le plan de masse 17 et les métallisations U1, U2, Rx1, Rx2, Tx1, Tx2 était de 2 cm. L'immunité du circuit était alors d'environ 650 V au lieu de 450 V environ en l'absence du couplage capacitif. Dans un autre exemple où on avait C=220 pF, L=40 nH et d=4 cm, on a observé une immunité d'environ 900 V.

## Revendications

1. Equipement de télécommunication comportant des premier et second connecteurs (7,8) pour le raccordement à des première et seconde lignes (9,10), respectivement, et un circuit imprimé multicouche (4), dont une région (5) supporte des composants de traitement de signal (6), chacune des première et seconde lignes comportant au moins deux conducteurs électriques, le circuit imprimé incorporant des liaisons électriques (16) entre les connecteurs et lesdits composants, **caractérisé en ce que** le circuit imprimé incorpore en outre des premières métallisations (U1,U2) associées au premier connecteur (7) qui les relie respectivement aux conducteurs de la première ligne (9), et des secondes métallisations (Rx1,Rx2,Tx1,Tx2) associées au second connecteur (8) qui les relie respectivement aux conducteurs de la seconde ligne (10), et **en ce que** les premières métallisations et les secondes métallisations appartiennent à des couches différentes du circuit imprimé (4) et sont situées les unes en face des autres pour réaliser un couplage capacitif entre les deux lignes (9, 10).

2. Equipement selon la revendication 1, dans lequel ledit couplage capacitif entre les deux lignes est de 150 à 300 picofarads.

3. Equipement selon la revendication 1 ou 2, dans lequel la région (5) du circuit imprimé supportant les composants de traitement de signal (6) comporte un plan de masse (17) situé à une distance des connecteurs (7,8) et des premières et secondes métallisations (U1,U2,Rx1,Rx2,Tx1,Tx2)appropriée pour minimiser le risque que ledit plan de masse soit atteint par une perturbation rapide propagée par rayonnement depuis le bord du circuit imprimé intégrant lesdits connecteurs et métallisations.

4. Equipement selon la revendication 3, dans lequel le plan de masse (17) est éloigné des connecteurs (7,8) et des premières et secondes métallisations (U1,U2,Rx1,Rx2, Tx1,Tx2) d'au moins 2 centimètres.

5. Equipement selon la revendication 3 ou 4, dans lequel les liaisons électriques entre les connecteurs (7,8) 9 et les composants (6) consistent essentiellement en des pistes métalliques (16) sensiblement parallèles que les connecteurs relient respectivement aux conducteurs électriques des lignes (9,10).

6. Equipement selon la revendication 5, dans lequel lesdites pistes métalliques (16) présentent une inductance longitudinale d'au moins 20 nanohenrys pour chaque paire de pistes.

7. Equipement selon l'une quelconque des revendications 1 à 6, dans lequel la première ligne (9) comporte deux conducteurs tandis que la seconde ligne (10) comporte quatre conducteurs, dans lequel les premières métallisations (U1,U2) sont situées dans une même couche du circuit imprimé (4), et dans lequel les secondes métallisations (Rx1,Rx2,Tx1,Tx2) sont réparties dans deux couches du circuit imprimé situées de part et d'autre de la couche des premières métallisations.

8. Equipement selon la revendication 7, dans lequel les premières métallisations (U1,U2) consistent en deux bandes sensiblement parallèles à un bord du circuit imprimé (4) où sont situés les connecteurs (7,8), et les secondes métallisations consistent en deux paires (Rx1,Rx2;Tx1,Tx2) de plaques, les plaques de chaque paire étant placées l'une en face de l'autre et prenant en sandwich deux tronçons respectifs desdites bandes.

## Claims

1. Telecommunication equipment comprising a first connector and a second connector (7,8) for connection to a first line and a second line (9,10), respectively, and a multilayer printed circuit (4) which has a region (5) which supports signal processing components (6), each of the first and second lines including at least two electrical conductors, the printed circuit including electrical links (16) between the connectors and the said components, **characterized in that** the printed circuit further includes first metallizations (U1, U2) associated to the first connector (7) which links them respectively to the conductors of the first line (9), and second metallizations (Rx1, Rx2, Tx1, Tx2) associated to the second connector (8) which links them respectively to the conductors of the second line (10), and **in that** the first metallizations and the second metallizations belong to different layers of the printed circuit (4) and are located in opposing relationship to form a capacitive coupling between the two lines (9,10).

2. Equipment according to claim 1, wherein said capacitive coupling between the two lines is 150 to 300 picofarads.

3. Equipment according to claim 1 or 2, wherein the region (5) of the printed circuit supporting the signal processing components (6) includes an earth plane (17) located a distance away from the connectors (7,8) and from the first and second metallizations (U1, U2, Rx1, Rx2, Tx1, Tx2), said distance being suited to minimize the risk that the said earth plane be reached by a fast disruption propagated by radiation from the edge of the printed circuit including the said connectors and metallizations.

4. Equipment according to claim 3, wherein the earth plane (17) is at least 2 centimetres away from the connectors (7,8) and from the first and second metallizations (U1, U2, Rx1, Rx2, Tx1, Tx2).

5. Equipment according to claim 3 or 4, wherein the electrical links between the connectors (7,8) and the components (6) consist essentially of substantially parallel metal tracks (16) which the connectors link respectively to the electrical conductors of the lines (9,10).

6. Equipment according to claim 5, wherein said metal tracks (16) exhibit a longitudinal inductance of at least 20 nanohenrys for each pair of tracks.

7. Equipment according to any one of the claims 1 to 6, wherein the first line (9) includes two conductors while the second line (10) includes four conductors, wherein the first metallizations (U1, U2) are situated in a same layer of the printed circuit (4), and wherein the second metallizations (Rx1, Rx2; Tx1, Tx2) are distributed into two layers of the printed circuit which are situated either side of the layer of the first metallizations.

8. Equipment according to claim 7, wherein the first metallizations (U1, U2) consist of two strips substantially parallel to an edge of the printed circuit (4) at which the connectors (7,8) are situated, and the second metallizations consist of two pairs (Rx1, Rx2; Tx1, Tx2) of plates, the plates of each pair being placed facing one another and sandwiching two respective portions of the said strips.

## Patentansprüche

1. Telekommunikationsvorrichtung, die einen ersten und einen zweiten Anschluss (7, 8) für den Anschluss an eine erste bzw. eine zweite Leitung (9, 10) und einen mehrschichtigen gedruckten Schaltkreis (4) umfasst, wovon ein Bereich (5) Signalverarbeitungskomponenten (6) trägt, wobei jede von erster und zweiter Leitung mindestens zwei elektrische Leiter umfasst und der gedruckte Schaltkreis elektrische Verbindungen (16) zwischen den Anschlüssen und diesen Komponenten enthält, **dadurch gekennzeichnet, dass** der gedruckte Schaltkreis außerdem erste feste elektrische Kontakte (U1, U2), die mit dem ersten Anschluss (7) verbunden sind, der sie jeweils mit den Leitern der ersten Leitung (9) verbindet, und zweite feste elektrische Kontakte (Rx1, Rx2, Tx1, Tx2), die mit dem zweiten Anschluss (8) verbunden sind, der sie jeweils mit den Leitern der zweiten Leitung (10) verbindet, enthält, und dass die ersten festen
elektrischen Kontakte und die zweiten festen elektrischen Kontakte zu verschiedenen Schichten des gedruckten Schaltkreises (4) gehören und sich einander gegenüberstehen, um zwischen den zwei Leitungen (9, 10) eine kapazitive Kopplung herzustellen.

2. Vorrichtung nach Anspruch 1, bei welcher die kapazitive Kopplung zwischen den zwei Leitungen 150 bis 300 Pikofarad beträgt.

3. Vorrichtung nach Anspruch 1 oder 2, bei welcher der Bereich (5) des gedruckten Schaltkreises, der die Signalverarbeitungskomponenten (6) trägt, eine Masseebene (17) umfasst, die sich in einem Abstand von den Anschlüssen (7, 8) und den ersten und zweiten festen elektrischen Kontakten (U1, U2, Rx1, Rx2, Tx1, Tx2) befindet, der geeignet ist, die Gefahr zu minimieren, dass die Masseebene von einer schnellen Störung erreicht wird, die von einer Strahlung ab dem Rand des gedruckten Schaltkreises übertragen wird, der diese Anschlüsse und festen elektrischen Kontakte integriert.

4. Vorrichtung nach Anspruch 3, bei welcher die Masseebene (17) von den Anschlüssen (7, 8) und den ersten und zweiten festen elektrischen Kontakten (U1, U2, Rx1, Rx2, Tx1, Tx2) mindestens 2 Zentimeter entfernt ist.

5. Vorrichtung nach Anspruch 3 oder 4, bei welcher die elektrischen Verbindungen zwischen den Anschlüssen (7, 8) 9 und den Komponenten (6) im Wesentlichen von metallischen Bahnen (16) gebildet werden, die im Wesentlichen parallel wie die Anschlüsse sind, die mit den jeweiligen elektrischen Leitern der Leitungen (9, 10) verbinden.

6. Vorrichtung nach Anspruch 5, bei welcher die metallischen Bahnen (16) eine Längsinduktivität von mindestens 20 Nanohenry für jedes Bahnpaar aufweisen.

7. Vorrichtung nach einem der Ansprüche 1 bis 6, bei welcher die erste Leitung (9) zwei Leiter umfasst, während die zweite Leitung (10) vier Leiter umfasst, wobei sich die ersten festen elektrischen Kontakte (U1, U2) in ein und derselben Schicht des gedruckten Schaltkreises (4) befinden und die zweiten festen elektrischen Kontakte (Rx1, Rx2, Tx1, Tx2) auf zwei Schichten des gedruckten Schaltkreises verteilt sind und sich auf beiden Seiten der Schicht der ersten festen elektrischen Kontakte befinden.

8. Vorrichtung nach Anspruch 7, bei welcher die ersten festen elektrischen Kontakte (U1, U2) aus zwei Bändern bestehen, die im Wesentlichen parallel zu einem Rand des gedruckten Schaltkreises (4) verlaufen, wo sich die Anschlüsse (7, 8) befinden, und die zweiten festen elektrischen Kontakte aus zwei Plattenpaaren (Rx1, Rx2; Tx1, Tx2) bestehen, wobei die Platten eines jeden Paares einander gegenüber angeordnet sind und zwei jeweilige Abschnitte dieser Bänder sandwichartig aufnehmen.
